# EUROPEAN PATENT SPECIFICATION

(11) **EP 2 398 932 B1**
(45) Date of publication and mention of the grant of the patent: **14.11.2012**
(21) Application number: 10705700.2
(22) Date of filing: 12.02.2010
(51) Int. Cl.: C23C 14/12, C23C 14/24

(54) **SIMPLIFIED POWDER FEEDING AND VAPORIZATION APPARATUS**
VEREINFACHTE PULVERZUFÜHRUNGS- UND -VERDAMPFUNGSVORRICHTUNG
APPAREIL DE DISTRIBUTION ET DE VAPORISATION DE POUDRE SIMPLIFIÉ

(30) Priority: 17.02.2009 US 371940
(43) Date of publication of application: 28.12.2011
(73) Proprietor: Global OLED Technology LLC, Herndon, VA 20171 (US)
(72) Inventor: LONG, Michael, Hilton NY 14468 (US)
(74) Representative: Wibbelmann, Jobst
(86) International application number: PCT/US2010/024038
(87) International publication number: WO 2010/096340

(56) References cited:
- JP-A- 10 330 920
- US-A1- 2006 177 576

## Description

### FIELD OF THE INVENTION

The present invention relates to metering of particulate materials, over a large range of feed rates, into a vaporization apparatus.

### BACKGROUND OF THE INVENTION

There is a need to be able to dispense small quantities of finely divided powders with high weight or volume accuracy for batch processes operating in a vacuum. There is also a need to dispense powders in a continuous stream with a high accuracy and consistency in the dispensing rate for continuous processes operating in a vacuum. For some processes, for example, the weight accuracy necessary is plus or minus 10 micrograms and the rate consistency is plus or minus 10 micrograms per second.

The electronics industry in particular has a need to meter small quantities of powdered materials to a vaporization zone for direct vapor deposition or for precursors in chemical vapor deposition (CVD). There is also a need to be able to accurately and precisely meter material amounts at much higher rates, for example 1000 micrograms per second. In many systems, it would be advantageous to be able to meter powdered materials over the range of 1 to 1000 micrograms with the same equipment. Organic light emitting diode devices (OLEDs), for instance, have a light-emitting layer that often contains a host and a dopant that are deposited in amounts differing by two to three orders of magnitude. There would be a great advantage in OLED manufacturing to be able to independently, and continuously, meter powdered organic materials to a vaporization region using a common transport design for host, co-host and dopant materials.

It is well known that precisely metering small amounts of powdered materials is difficult. There are numerous examples of systems in the pharmaceutical industry, for example, that make use additional materials as carriers and additives to facilitate the accurate dispensing of powdered materials. Carriers that have been used include inert gases, liquids, and solids. The use of any sort of additive increases the material transport complexity, for the carrier or additive needs to be added, removed, and handled separately from the actual material of interest. The use of carriers also increases the risk of contamination, which is particularly detrimental in the pharmaceutical and electronics manufacturing industries where there is a particular need to meter materials.

In U.S. Patent No. 3,754,529, Fleischner describes an auger device for transporting powdered material that has been mixed with an inert carrier, preferably sand. The ratio of active material to sand is reported to be 1:9. Transporting a mixture that is mostly inert carrier effectively reduces the powder dispensing accuracy requirements by an order of magnitude if the mixture is homogeneous, but this method adds cost and complexity to the system and increases the potential for the introduction of contaminates into the material feed.

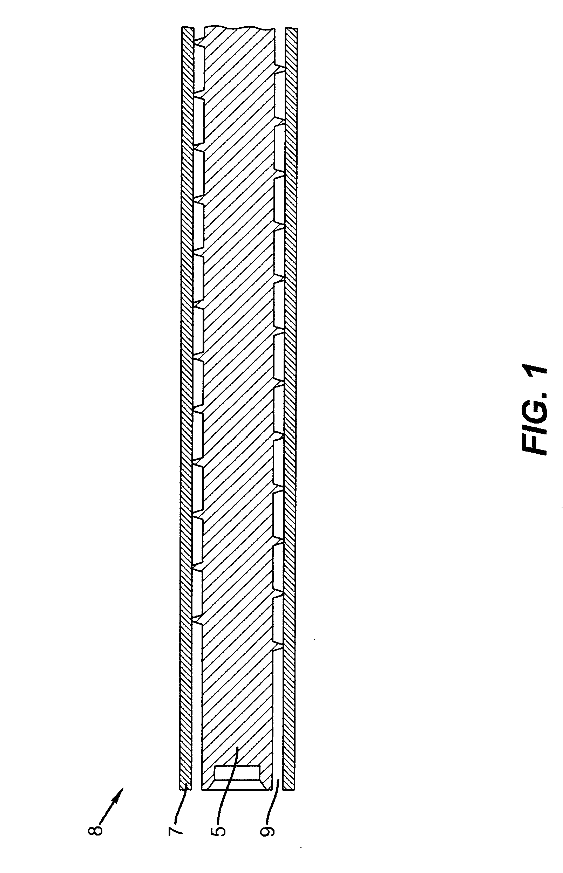

Commonly assigned U.S. Patent Application Publication Nos. 2006/0062918 and No. 2006/0177576 use a traditional auger design to meter powders in a vaporization device, where there is a patterned screw within a smooth barrel. FIG. 1 shows a cross-sectional view of a typical prior art auger structure 8 showing a patterned auger screw 5 within a smooth barrel 7. The terminal end of auger screw 5 can be configured to have a thread-free portion 9 having a constant circular cross-section over a small length to constrain the consolidated particulate material to form a narrow annular or tubular shape. One of the problems with using this type of auger structure with powders is varying discharge rate. The discharge rate has been observed to vary cyclically with the angular orientation of auger screw **5.** The quantity of material discharged by the auger from revolution to revolution can be quite reproducible, but within a revolution it is quite variable. Another problem with auger structures is that they are prone to jamming if the powder is not free flowing or tends to pack into a consolidated mass. Their use with powders whose particle size is less than 50 microns tends to be problematic.

Additional difficulty is encountered if the powder-dispensing system is used to deliver powder to a vaporization process. Many organic materials are subject to thermal decomposition when exposed to high temperatures for extended periods of time, so vaporization systems are advantageously designed to actively cool the powder in a reservoir and the powder feeding mechanism, forcing the material to undergo a rapid temperature rise to the vaporization temperature in a short period of time as it is dispensed into the vaporization apparatus. The difficulty in maintaining adjacent hot and cold regions is that vapor from the heated powder will condense on surfaces cooler than the vapor's condensation temperature and quickly foul most powder delivery systems.

Vapor deposition systems of particular interest are those designed for manufacturing organic light emitting diode (OLED) devices. An OLED device includes a substrate, an anode, a hole-transporting layer made of an organic compound, an organic luminescent layer with suitable dopants, an organic electron-transporting layer, and a cathode. OLED devices are attractive because of their low driving voltage, high luminance, wide-angle viewing and capability for full-color flat emission displays. Tang et al. described this multilayer OLED device in their U.S. Patent Nos. 4,769,292 and 4,885,211.

Physical vapor deposition in a vacuum environment is the principal method of depositing thin organic material films as used in small molecule OLED devices. Such methods are well known, for example Barr in U.S. Patent No. 2,447,789 and Tanabe et al. in EP 0 982 411. The organic materials used for OLED devices are often subject to degradation when maintained at or near the desired rate-dependent vaporization temperature for extended periods of time. Exposure of sensitive organic materials to higher temperatures can cause changes in the structure of the molecules and associated changes in material properties.

To overcome the thermal sensitivity of these materials, only small quantities of organic materials have been loaded in prior art deposition sources, and they are heated as little as possible. In this manner, the material is consumed before it has reached the temperature exposure threshold to cause significant degradation. The limitations with this practice are that the available vaporization rate is very low due to the limitation on heater temperature, and the operation time of the source is very short due to the small quantity of material present in the source. In the prior art, it has been necessary to vent the deposition chamber, disassemble and clean the vapor source, refill the source, reestablish vacuum in the deposition chamber, and degas the just-introduced organic material over several hours before resuming operation. The low deposition rate and the frequent and time-consuming process associated with recharging a source has placed substantial limitations on the throughput of OLED manufacturing facilities.

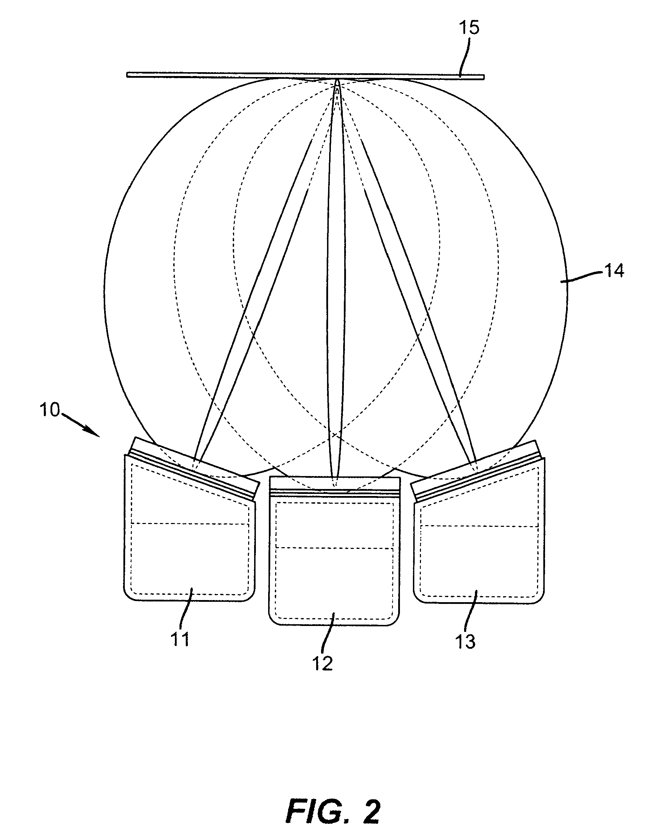

A secondary consequence of heating the entire organic material charge to roughly the same temperature is that it is impractical to mix additional organic materials, such as dopants, with a host material unless the vaporization behavior and vapor pressure of the dopant is very close to that of the host material. Additionally, the standard use of separate sources creates a gradient effect in the deposited film where the material in the source closest to the advancing substrate is over-represented in the initial film immediately adjacent the substrate while the material in the last source is over represented in the final film surface. This gradient co-deposition is unavoidable in prior art sources where a different single material is vaporized from each of multiple sources directly onto a substrate. The gradient in the deposited film is especially evident when the contribution of either of the end sources is more than a few percent of the central source, such as when a co-host is used. FIG. 2 shows a cross-sectional view of such a prior-art vaporization device **10,** which includes three individual sources **11,12,** and **13** for vaporizing organic material. Vapor plume **14** is preferably homogeneous in the materials from the different sources, but in fact varies in composition from side to side resulting in a non-homogeneous coating on substrate **15.**

Commonly assigned U.S. Patent Application Publication Nos. 2006/0062918 and 2006/0062919 overcome many of the shortcomings of the use of separate point sources by metering materials to a flash vaporization zone. U.S. Patent Application Publication No. 2006/0062918 teaches the metering of host and dopant mixtures in a single powder transport mechanism, and using a manifold to distribute the vapor to the substrate. U.S. Patent Application Publication No. 2006/062919 discloses the ability to mix organic vapors in the manifold and deliver a mixture of materials to the substrate surface. However, none of these earlier teachings anticipates the need to have independent metering control for the host and dopant materials. The transport mechanisms are therefore unable, by virtue of design, to meter at the low rates, 1-10 micrograms/second, required for an independent dopant feed.

U.S. Patent Application Publication Nos. 2007/0084700 and 2006/0157322, U.S. Patent Nos. 6,832,887 and 7.044.288 disclose powder feeding pumps, which move powders from an entry port to a discharge port using parallel spaced disks. The disks rotate within a housing having a volume that increases from the input port to the discharge port. These powder feeding pumps are intended for use with much larger particle size powders and are not adapted to metering powder on a milligram or microgram basis.

JP 10 330 920 A shows a vapour deposition device in which organic material is supplied from a hopper to an endless belt by an agitation device and is then transferred to a heating device to be vaporized.

There continues to be a need to precisely control the metering of milligram to microgram quantities of powdered material into a vaporization apparatus.

### SUMMARY OF THE INVENTION

There is a continued need to precisely control the metering and delivery of milligram to microgram quantities of particulate material to a vaporization device.

This object is achieved by an apparatus for vaporizing a particulate material, comprising:
a. a metering apparatus including:
   i. a reservoir for receiving particulate material;
   ii. the reservoir having an opening for discharging the particulate material into a vaporizing chamber;
   iii. a rotatable wire wheel brush disposed in the reservoir;
   iv. wherein the dimensions of the reservoir and the wire wheel brush are selected so that the wire wheel brush cooperates with the interior walls of the reservoir to fluidize the particulate material and wherein a metered portion of the particulate material is entrained in the tines of the wire wheel brush and subsequently forcefully released into the reservoir opening; and
b. a flash evaporator that receives and vaporizes the metered material.

It is an advantage of this invention that it can provide adjustable controlled metering and vaporization of small quantities of particulate material more uniformly than many prior art devices. The particulate material transport apparatus of the present invention can accurately deliver small amounts of particulate material such as 1 microgram per second, as well as much larger amounts, such as up to 1000 micrograms per second. It is a further advantage of the present invention that it can meter particulate materials uniformly without the use of a carrier, such as an inert gas, liquid or solid. It is a further advantage of the present invention that it can maintain a steady vaporization rate with a continuously replenished charge of particulate material and with no heater temperature change required as the source material is consumed. It is a further advantage of the present invention that the particulate material is maintained at lower temperature in the material reservoir and is heated only as it is discharged into the associated vaporizing chamber. The device permits extended operation of the source with substantially higher vaporization rates than in many prior art devices and has substantially reduced risk of degrading even very temperature-sensitive organic materials. It is a further advantage of the present invention that it can be used in a vaporization system for independently controlling multiple feed rates, such as dopant and host. It is a further advantage of this invention that it permits rapid starting and stopping of vaporization. It is a further advantage of this invention that it can deliver controlled volumes of vapor and thereby control the deposited film thickness in area deposition processes. It is a further advantage of the present invention that it can provide a vapor source in any orientation, which is frequently not possible with prior-art devices.

### BRIEF DESCRIPTION OF THE DRAWINGS

FIG. 1 shows a cross-sectional view of an auger-delivery portion of a prior-art vaporization device;
FIG. 2 shows a cross-sectional view of a portion of a different prior-art vaporization device;
FIG. 3 shows a three-dimensional cross-sectional view of one embodiment of an apparatus according to the present invention;
FIG. 4 shows a cross-sectional view of a portion of the inventive apparatus of FIG. 3;
FIG. 5 shows a cross-sectional view of a portion of FIG. 4 in greater detail;
FIG. 6 shows a three-dimensional cross-sectional view of a portion of the inventive apparatus of FIG. 3;
FIG. 7 shows a three-dimensional view of the rotatable flash evaporator of FIG. 3 showing a magnetic coupling for driving the rotatable flash evaporator; and
FIG. 8 shows a cross-sectional view of an embodiment of the apparatus of this invention in another orientation.

### DETAILED DESCRIPTION OF THE INVENTION

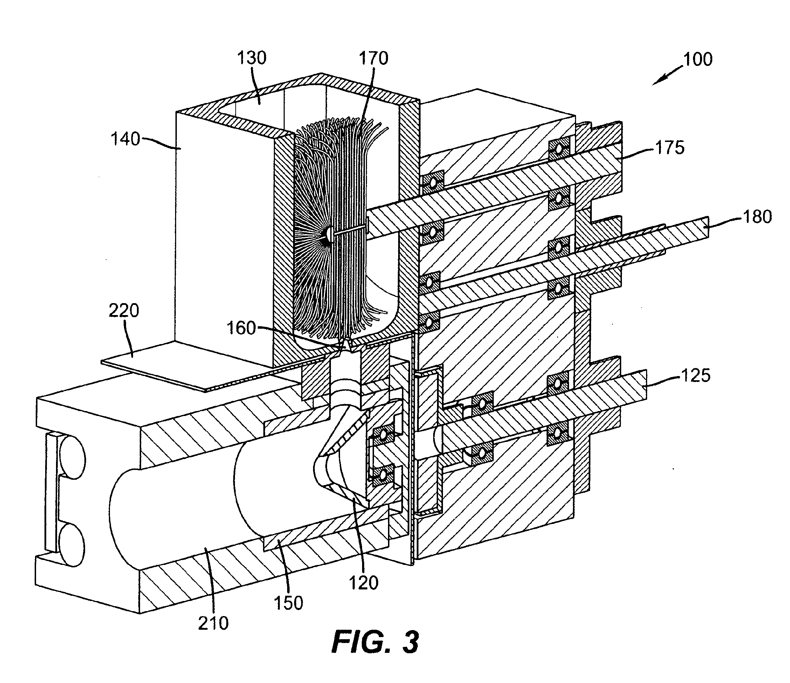

Turning now to FIG. 3, there is shown a three-dimensional cross-sectional view of one embodiment of an apparatus according to the present invention. Vaporizing apparatus **100** is an apparatus for vaporizing particulate material. Vaporizing apparatus **100** includes a metering apparatus, which includes a housing having a reservoir for receiving particulate material, an opening in the reservoir for discharging the material into a vaporizing chamber, and a rotatable wire brush wheel disposed in the reservoir. These components will be described in more detail. Reservoir **130** is in housing **140** and is for receiving particulate material. The particulate material can include a single component, or can include two or more different material components, each one having a different vaporization temperature. Although not shown, reservoir **130** can include a larger storage and feeding apparatus above it to increase the volume of particulate material that can be loaded. Such containers and feeding apparatus have been described by Long et al. in commonly assigned U.S. Patent No. 7,288,285. Housing **140** is preferably constructed of thermally conductive material, such as aluminum, which can be actively cooled and serves to maintain the particulate material in reservoir **130** at a temperature well below its effective vaporization temperature.

Rotatable wire wheel brush **170** is disposed in reservoir **130** and is preferably constructed of thermally conductive material such as nickel or stainless steel, which can be actively cooled and helps to maintain the particulate material retained within its bristles at a temperature well below the effective vaporization temperature. Hard coatings such as titanium nitride or diamond-like carbon are advantageously applied to the interior of housing **140.** Wire wheel brush **170** can be rotated by a motor (not shown) attached to shaft **175.** Alternatively, a motor can be attached to shaft **180,** which can then drive shafts **175** and **125,** e.g. by a gear arrangement. Shaft **125** is used to rotate flash evaporator **120,** which will be described below. Reservoir **130** also includes an opening at the bottom for discharging particulate material at a metered rate into vaporizing chamber **210.** Vaporizing apparatus **100** also includes a rotatable flash evaporator **120** within vaporizing chamber **210.** Flash evaporator **120** receives the particulate material discharged into vaporizing chamber **210** and vaporizes the metered material. Vaporizing chamber **210** can also include a cylindrical foam element **150** around a portion of its walls. Vaporizing apparatus **100** can further optionally include a pressure sensor (not shown) to measure the pressure inside vaporizing chamber **210,** and which can therefore monitor the rate of material vaporization. It is also useful to have an insulator **220** between vaporizing chamber **210** and housing **140** to reduce heat transfer to the housing. Insulator **220** can include synthetic mica such as that marketed by the Cogebi Group, an insulating ceramic material, a thin gap, or simply light contact between vaporizing chamber **210** and housing **140.**

The dimensions of reservoir **130** and wire wheel brush **170** are selected so that the wire wheel brush cooperates with the interior walls of the reservoir to fluidize the particulate material. A metered portion of the particulate material is entrained in the tines of the wire wheel brush and subsequently forcefully released into the reservoir opening; Wire wheel brush **170** rotates and is in contact with a portion of the wall of a particulate material reservoir **130.** The brush pushes particulate material against the wall and through opening **160** in the wall of reservoir **130** to transfer particulate material from the reservoir to vaporizing chamber **210.** As the brush rotates through particulate material in the reservoir, the particles are agitated or fluidized around the brush and tend to be entrained in the spaces between the tines of the brush. The tines rotate into contact with the walls of reservoir **130** and are displaced from their free position. As the brush continues to rotate, some of the tines pass over opening **160** in the wall of the reservoir, allowing those tines to spring back, at least partially, toward their rest position. The sudden displacement of these tines fluidizes the particulate material in the vicinity of opening **160,** causing material particles to be forcefully released into the opening. The contact between the tines and the wall of the reservoir continually removes any condensate that can otherwise adhere there. Additionally, by deforming the tines as they rotate against the wall of the reservoir and allowing them to straighten somewhat as they pass over opening **160,** causes the tines to project to some degree into the opening to further dislodge condensate and allow reliable operation even where condensate fouling would normally be problematic.

Wire wheel brush **170,** in cooperation with reservoir **130,** therefore acts to agitate or fluidize particulate material in the reservoir, to transport the material from the reservoir to discharge opening **160,** to locally fluidize material at the discharge opening, and to dislodge condensate that collects around the opening on a continual basis.

A wire wheel brush having an outer diameter of 40 mm, composed of a multitude of 0.05 mm diameter stainless steel tines whose free length is 14 mm has proven to be effective in metering free flowing powders. Other wheel diameters will also be effective. It is important that the tines be sufficiently compliant to allow that they be deformed when contacting the interior walls of the reservoir and can spring back when passing over the discharge opening.

The feed rate uniformity is improved when the particulate material in proximity to the discharge opening is fluidized by agitation, e.g. by rotation of the rotatable wire wheel brush and the localized spring action of the tines passing over the discharge opening. Wire wheel brush **170** is well adapted to feeding mixed-component particle materials as it imparts very little energy to the bulk of the particulate material in the reservoir and is therefore not likely to cause particle separation by size or density.

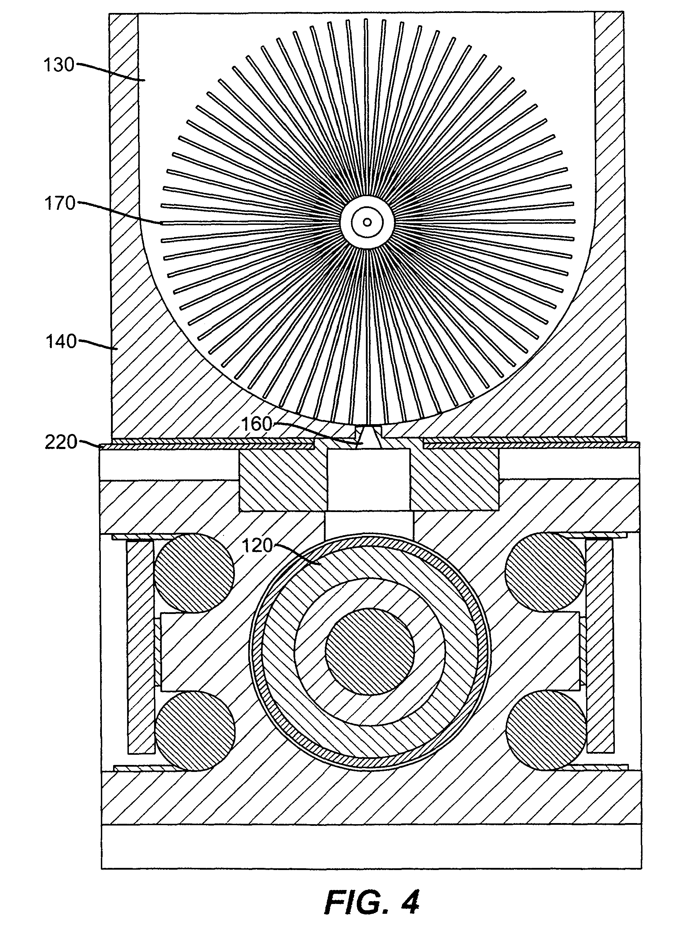

Turning now to FIG. 4, there is shown a cross-sectional view of a portion of the inventive apparatus of FIG. 3 in the plane of opening **160** in housing **140** and the middle of rotatable wire wheel brush **170.** Wire wheel brush **170** is aligned with opening **160.** Flash evaporator **120** and cylindrical foam element **150** (which can be seen more clearly in FIG. 3) are desirably reticulated vitreous carbon as described by Long et al. in commonly assigned U.S. Patent Application 11/834,039, or reticulated nickel, tungsten, titanium, molybdenum or tantalum. Such reticulated material allows particulate material that falls into vaporizing chamber **210** to be largely trapped by flash evaporator **120** and heated rapidly to vaporize it. Some particulate material can rebound from, or be ejected by, flash evaporator **120,** or can simply fall from it. Cylindrical foam element **150** acts as a secondary heating element to rapidly vaporize these particles. Flash evaporator **120** and cylindrical foam element **150** can be heated directly. Alternatively, evaporator enclosure **210,** within which flash evaporator **120** and cylindrical foam element **150** are located, can be heated. Reservoir **130** and housing **140** can be actively cooled. Wire wheel brush **170,** and particulate material entrained in it, can be maintained by the active cooling at a temperature below the desired vaporization temperature of the particulate material. Only a small portion of particulate material—the portion that reaches and falls through second opening **160**—is heated to the rate-dependent vaporization temperature, while the bulk of the material is kept well below the vaporization temperature. Wire wheel brush **170** can keep the particulate material well entrained in its tines so that when it is stopped, the particulate material is largely prevented from entering opening **160.** Therefore, it is possible to rapidly stop and start the vaporization by stopping and starting the rotation of wire wheel brush **170.** The vaporization can be stopped when a substrate surface is not being coated so as to conserve organic material and minimize contamination of any associated apparatus, such as the walls of vaporizing chamber **210.** This is an advantage over many prior art devices that use temperature to control the rate of vaporization, and which do not permit rapid stopping and starting, or rapid rate of vaporization change.

The residence time of the material at elevated temperature, that is, at the rate-dependent vaporization temperature, is orders of magnitude less than many prior art devices and methods (seconds vs. hours or days in the prior art), which permits heating material to higher temperatures than in the prior art. Thus, the current device and method can achieve substantially higher vaporization rates, without causing appreciable degradation of the organic material components because the product of exposure time and temperature is substantially lower than in prior art devices.

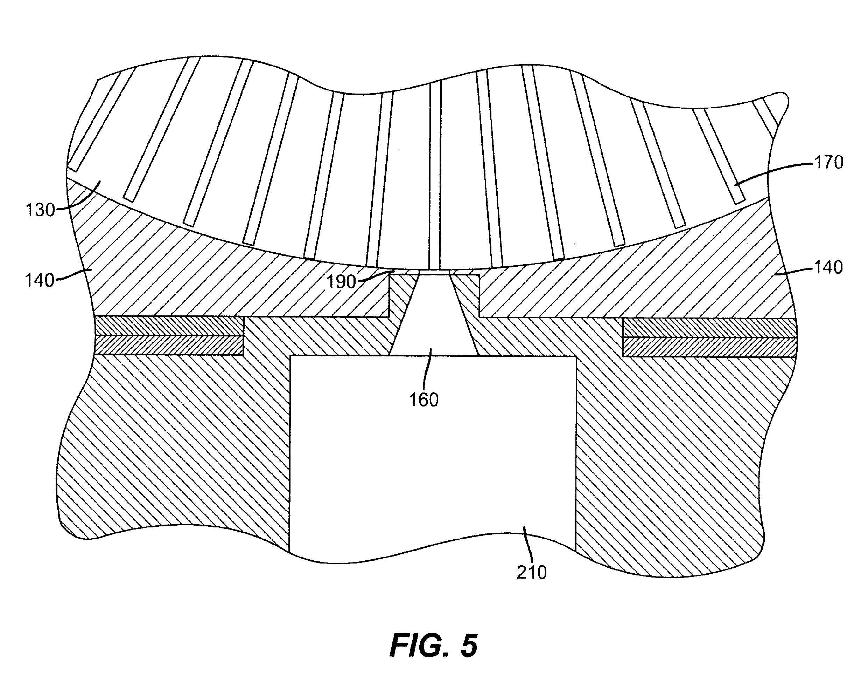

Turning now to FIG. 5, there is shown a portion of the apparatus of FIG. 4 in greater detail. Opening **160** is at the bottom of reservoir **130** for the transfer of particulate material into vaporizing chamber **210,** which is heated. Heat transfer from vaporizing chamber **210** to the particulate material in reservoir **130** can heat the particulate material, potentially leading to material degradation, melting, or vaporization. To prevent such heat transfer, divider **190** is a part of housing **140,** which is cooled, and prevents heating of particulate material in the vicinity of opening **160** in reservoir **130.**

Opening **160** has an increasing cross sectional area as it penetrates into vaporizing chamber **210** to encourage the material dislodged from the wire wheel brush **170** to fall into vaporizing chamber **210** without clinging to the walls of the opening. The light contact between rotatable wire wheel brush **170** and opening **160** of both housing **140** and vaporizing chamber **210** creates a positive displacement metering configuration that forcefully releases the material out of the reservoir and into vaporizing chamber **210** without reliance on gravity. The rate of particulate material transfer into vaporizing chamber **210** can be controlled by controlling the rotation rate of wire wheel brush **170,** which entrains a metered portion of particulate material per unit of angular displacement.

Experimentally, it has been observed that fine particulate material is considerably more difficult to meter in a partial vacuum below half an atmosphere. The particulate material agglomerates as residual air molecules are removed, and behaves more like a solid than a pourable powder. Despite this tendency, the material feeding and vaporizing device of this disclosure has proven capable of dispensing materials with a particle size dispersion below 50 microns as well as materials prepared to have particle size dispersions between 50 and 100 microns and between 100 and 200 microns.

Managing condensation in powder-fed vaporization systems is extremely important, as this is a primary cause of material feed problems and material degradation or fractionalization. Opening **160** to vaporizing chamber **210** is made sufficiently large to permit the material to pass into the vaporizing chamber, but at less than 1 mm diameter, the opening is purposely made to have a low conductance to the backflow of vapor. All of the points of condensation in this device are self limiting and confined to very small areas. After an initial vaporization period, the material feed rate will stabilize.

This configuration substantially increases the attainable temperature gradient in the particulate material between the temperature of wire wheel brush **170** and that of vaporizing chamber **210.** This gradient prevents leaching of more volatile constituents from bulk volumes of mixed-component materials and enables a single source to co-deposit multiple-particulate materials.

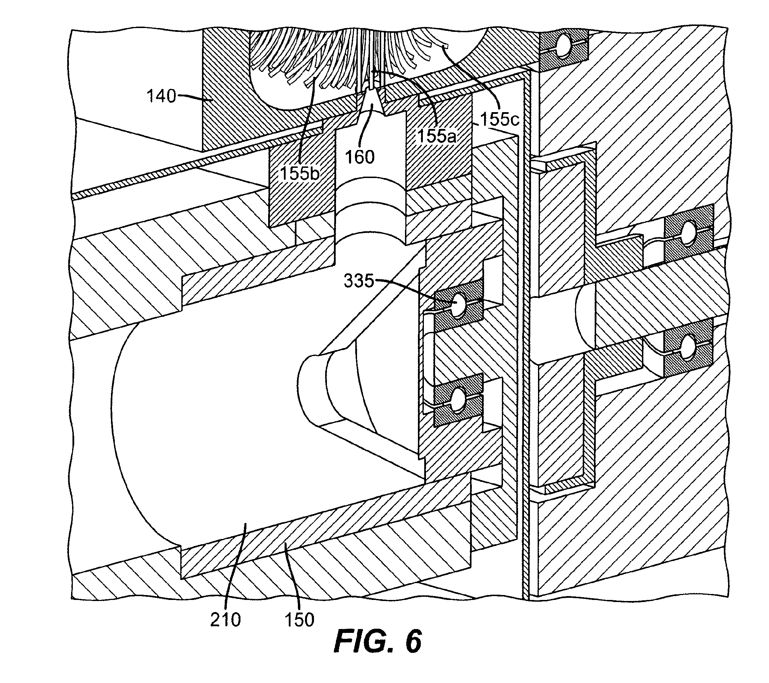

Turning now to FIG. 6, there is shown a three-dimensional cross-sectional view of a portion of the apparatus of FIG. 3. Wire wheel brush **170** comprises multiple tines. Only those tines aligned with opening **160,** e.g. tines **155a,** will actually sweep particulate material into opening **160.** Tines that are displaced to one side or the other, e.g. tines **155b** and **155c,** serve to scrape off particulate material that may be adhering to the inner walls of housing **140,** and to fluidize the particulate material for improved flow into opening **160.**

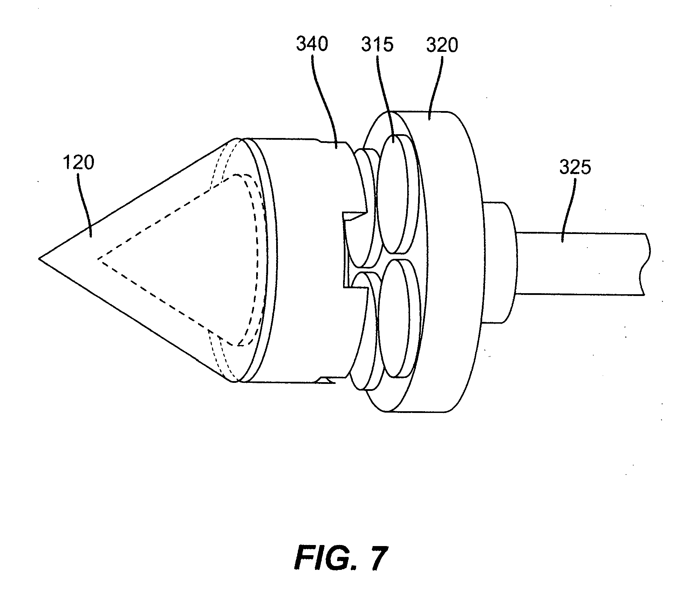

Turning now to FIG. 7, and referring also to FIG. 6, there is shown a three-dimensional view of the rotatable flash evaporator of FIG. 3 showing a magnetic coupling **320** for rotating rotatable flash evaporator **120** inside of vaporizing chamber **210** without physical contact between the cold magnetic drive coupling and the hot vaporization element or breach of the vapor integrity of vaporizing chamber **210.** This arrangement has been described by Long et al. in U.S. Patent Application 12/271,211. The coupling includes several magnets **315,** attached to a rotating drive shaft **325** via magnetic coupling **320,** that cooperate with drive lugs **340** attached to rotatable flash evaporator **120.** The flash evaporator and its attached drive lugs are supported on a ceramic bearing (bearing **335** in FIG. 6). The non-contact, magnetic drive between hot rotatable flash evaporator **120** and cold rotary drive shaft **325** prevents heat flow between them, thereby permitting rotatable flash evaporator **120** to be heated by radiation from vaporizing chamber **210** without requiring the use of additional heating elements that rotate with the flash evaporator or the complication of slip rings to transfer power to the additional heating elements. Magnetic coupling **320** further eliminates the need to seal around the rotary drive connection to rotatable flash evaporator **120.** The magnetic coupling is effective at temperatures in excess of 600°C because the magnets **315** are shielded and remain cold while the low carbon steel drive lugs **340** retain their low magnetic reluctance at temperatures approaching 700°C.

In practice, vaporization apparatus **100** is used as follows. Particulate material is received in reservoir **130,** which is formed in housing **140** as described above. Rotatable wire wheel brush **170** as described above is rotated in reservoir **130,** whereby wire wheel brush **170** entrains particulate material from reservoir **130** and discharges it through opening **160** to deliver metered amounts of particulate material to vaporizing chamber **210** and flash evaporator **120,** wherein the metered particulate material is flash evaporated.

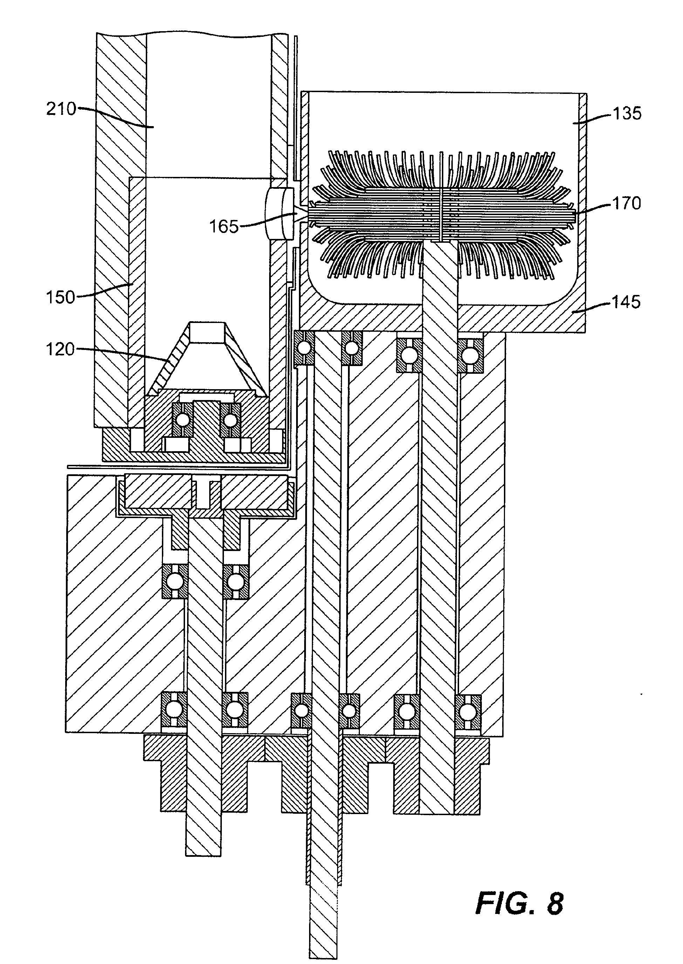

The material feeding and vaporizing device of this disclosure is effective at transporting particulate material when the wire brush wheel axis is horizontal as shown in FIGS. 3-6, but it can also be used in other orientations. The particulate material is forced into the wire brush wheel as it rotates and is retained therein sufficiently well to make its operation gravity-independent for many materials. Turning now to FIG. 8, there is shown an embodiment wherein the axis of the wire brush wheel **170** is oriented vertically. Wire wheel brush **170,** flash evaporator **120,** and vaporizing chamber **210** can be the same as described above but turned 90 degrees. Reservoir **135** in housing **145** has been modified to accommodate the change in orientation. Wire wheel brush **170** cooperates with reservoir **135** as described above to fluidize particulate material and to force material through opening **165** into vaporizing chamber **210** where it will fall onto flash evaporator **120** and be flash evaporated. These characteristics are significant in enabling the controlled vaporization of mixed component organic materials, and organic materials that liquefy before vaporizing.

### PARTS LIST

- 5: auger screw
- 7: barrel
- 8: auger structure
- 9: thread-free portion
- 10: vaporization device
- 11: source
- 12: source
- 13: source
- 14: vapor plume
- 15: substrate
- 100: vaporizing apparatus
- 120: flash evaporator
- 125: shaft
- 130: reservoir
- 135: reservoir
- 140: housing
- 145: housing
- 150: cylindrical foam element
- 155a: tines
- 155b: tines
- 155c: tines
- 160: opening
- 165: opening
- 170: wire wheel brush
- 175: shaft
- 180: shaft
- 190: divider
- 210: vaporizing chamber
- 220: insulator
- 315: magnet
- 320: magnetic coupling
- 325: drive shaft
- 335: bearing
- 340: drive lugs

## Claims

1. An apparatus for vaporizing a particulate material, comprising:
a. a metering apparatus including:
i. a reservoir for receiving particulate material;
ii. the reservoir having an opening for discharging the particulate material into a vaporizing chamber;
iii. a rotatable wire wheel brush disposed in the reservoir;
iv. wherein the dimensions of the reservoir and the wire wheel brush are selected so that the wire wheel brush cooperates with the interior walls of the reservoir to fluidize the particulate material and wherein a metered portion of the particulate material is entrained in the tines of the wire wheel brush and subsequently forcefully released into the reservoir opening; and
b. a flash evaporator that receives and vaporizes the metered material.

2. The vaporizing apparatus of claim 1 wherein the flash evaporator is rotatable.

3. The vaporizing apparatus of claim 2 wherein the flash evaporator is rotated via a magnetic coupling.

4. The vaporizing apparatus of claim 1 wherein the flash evaporator is within a vaporizing chamber.

5. The vaporizing apparatus of claim 4 wherein the vaporizing chamber further includes a cylindrical foam element as a secondary heating element.

## Patentansprüche

1. Vorrichtung zum Verdampfen eines teilchenförmigen Materials, umfassend:
a. eine Dosiereinrichtung, welche einschließt:
i. ein Reservoir zur Aufnahme von teilchenförmigem Material;
ii. wobei das Reservoir eine Öffnung für die Abgabe des teilchenförmigen Materials in eine Verdampfungskammer aufweist;
iii. eine drehbare Drahtrundbürste, die in dem Reservoir angeordnet ist;
iv. wobei die Abmessungen des Reservoirs und der Drahtrundbürste so gewählt sind, dass die Drahtrundbürste mit den Innenwänden des Reservoirs zusammenarbeitet, um das teilchenförmige Material zu fluidisieren, und wobei ein dosierter Teil des teilchenförmigen Materials in den Zinken den Drahtrundbürste mitgeschleppt wird und anschließend unter Krafteinwirkung in die Reservoiröffnung abgegeben wird; und
b. eine Flash-Verdampfungseinrichtung, die das dosierte Material aufnimmt und verdampft.

2. Verdampfungsvorrichtung nach Anspruch 1, bei der die Flash-Verdampfungseinrichtung drehbar ist.

3. Verdampfungsvorrichtung nach Anspruch 2, bei der die Flash-Verdampfungseinrichtung über eine Magnetkupplung gedreht wird.

4. Verdampfungsvorrichtung nach Anspruch 1, bei der die Flash-Verdampfungseinrichtung innerhalb einer Verdampfungskammer vorliegt.

5. Verdampfungsvorrichtung nach Anspruch 4, bei der die Verdampfungskammer weiter ein zylindrisches Schaumelement als sekundäres Heizelement einschließt.

## Revendications

1. Appareil de vaporisation d'une matière particulaire, comprenant:
a, un appareil de dosage incluant :
i. un réservoir pour recevoir la matière particulaire ;
ii. le réservoir ayant une ouverture pour décharger la matière particulaire à l'intérieur d'une chambre de vaporisation ;
iii. une brosse métallique circulaire rotative disposée dans le réservoir ;
iv. dans lequel les dimensions du réservoir et de la brosse métallique circulaire sont choisies de façon à ce que la brosse métallique circulaire coopère avec les parois intérieures du réservoir pour fluidiser la matière particulaire et dans lequel une partie dosée de la matière particulaire est entraînée dans les peignes de la brosse métallique circulaire et ensuite libérée avec force dans l'ouverture de réservoir ; et
b. un évaporateur éclair qui reçoit et vaporise la matière dosée.

2. Appareil de vaporisation selon la revendication 1, dans lequel l'évaporateur éclair est rotatif.

3. Appareil de vaporisation selon la revendication 2, dans lequel l'évaporateur éclair est mis en rotation par l'intermédiaire d'un accouplement magnétique.

4. Appareil de vaporisation selon la revendication 1, dans lequel l'évaporateur éclair est à l'intérieur d'une chambre de vaporisation.

5. Appareil de vaporisation selon la revendication 4, dans lequel la chambre de vaporisation inclut en outre un élément cylindrique en mousse comme élément de chauffage secondaire.
